# EUROPEAN PATENT SPECIFICATION

(11) **EP 2 904 634 B1**
(45) Date of publication and mention of the grant of the patent: **08.04.2020**
(21) Application number: 13789495.2
(22) Date of filing: 01.10.2013
(51) Int. Cl.: H01L 31/18, H01L 31/0236, H01L 21/67, H01L 21/677

(54) **COMBINED ETCH AND PASSIVATION OF SILICON SOLAR CELLS**
KOMBINIERTE ÄTZUNG UND PASSIVIERUNG VON SILICIUMSOLARZELLEN
GRAVURE ET PASSIVATION COMBINÉES DE PHOTOPILES AU SILICIUM

(30) Priority: 01.10.2012 IE S20120434
(43) Date of publication of application: 12.08.2015
(73) Proprietor: Ultra High Vacuum Solutions Ltd. T/A Nines Engineering, Dublin 24 (IE)
(72) Inventor: CLOCHARD, Laurent, Blackrock Co Dublin (IE)
(74) Representative: Purdylucey Intellectual Property
(86) International application number: PCT/EP2013/070443
(87) International publication number: WO 2014/053484

(56) References cited:
- WO-A1-2010/105703
- CN-A- 101 880 914
- US-A1- 2002 111 011

## Description

### Field of the Invention

The invention relates to a process for dry chemical texturing of a substrate. More particularly, the invention relates to a process for a combined dry chemical etching and passivation of a substrate (for example, silicon-based photovoltaic (PV) devices).

### Background to the Invention

Several etching steps are required in the manufacturing of solar cells. In particular, the front side of the cell needs to be etched in order to produce a surface texture that will lower the reflectivity of the wafer.

Most silicon (Si) etching processes use halogen, and more specifically fluorinated chemistry as described in CN 101 880 914 A, WO 2010/105703 A1 and WO 2011/141516 A2. Etching alters the surface state of the substrate, and can generate defects that act as recombination centres, degrading the electrical properties of the wafer.

In order to reduce these effects, the etched surface needs to be passivated in a subsequent process step, usually in a different process tool. Common passivation processes consist of plasma-enhanced chemical vapour deposition (PECVD) of silicon-nitride layers, or stacks of silicon-oxide and silicon-nitride layers. The conformality of such passivation method varies. It is usually suitable for a texture feature size of several micrometres. For sub-micrometer size features, these passivation methods are not efficient, resulting in very low carrier lifetime. Yet sub-micron texture have proved to be very efficient as a light trapping feature, resulting in very low surface reflectivity values that have the potential to increase the overall efficiency of the solar cell.

It is an object of the present invention to overcome at least one of the above-mentioned problems.

### Summary of the Invention

The problem to be solved by the present invention is to provide a process for etching features of any size without affecting the electrical properties of a substrate suitable for silicon solar cells. The process of the present invention can generate a strongly passivated and stable surface texture through a single dry process and tool.

According to the present invention there is provided, as set out in the appended claims, a process for etching a texture on a surface of a silicon substrate and passivating said substrate surface, wherein the silicon substrate is a silicon wafer or a silicon layer deposited on a substrate, the process comprising the steps of:
inserting a silicon substrate in a reactor chamber; heating the reaction chamber and substrate;
etching the surface of the substrate with a fluoride-containing etchant gas inside the chamber, while the substrate is being conveyed at a constant velocity; and
oxidising the textured, fluorinated surface of the substrate without exposing the substrate to air
wherein the steps are performed at atmospheric pressure and wherein the etchant gas is molecular florine.

The oxidation needs to be carried out on a fully fluorinated surface, i.e. before the fluorinated surface is to be exposed to air or any other reactive atmosphere that could trigger a chemical reaction at the surface. A reactive atmosphere could be, for example, any atmosphere comprising elements which react strongly with fluorine, expect Nitrogen, Helium, Argon, Neon and Krypton. The substrate is only exposed to nitrogen or any other neutral gas between the etching step and the oxidation step.

The process is carried out at atmospheric pressure. Atmospheric pressure is more convenient to use, in particular for applications requiring high throughput, like solar cell manufacturing.

In one example not forming part of the present invention the fluoride-containing gases may be selected from the group comprising tetrafluoromethane, trifluoromethane, carbonyl fluoride, sulphur hexafluoride, nitrogen trifluoride, xenon difluoride, and elemental fluorine.

The etchant gas is molecular Fluorine. The Fluorine concentration can be any concentration in a range of between about 5 to 100%, with or without dilution with N₂ or any other gas that does not react with molecular F₂, such as for example helium, argon, neon, and krypton.

Fluorine is known to be very good at passivating silicon surfaces, since the energy of the fluorine-Si bond is significant. The process of the present invention is designed to take full advantage of this high passivation properties and the fact that fluorine mixtures are commonly used and readily available as etching gas in both semiconductor and photovoltaic industries. The fluorinated gaseous etching process results in a surface fully saturated with fluorine. Previous experiments and literature show that fluorinated surfaces are very unstable, and quickly react when in contact with ambient air, mainly reacting with the water vapour. The advantage of this invention is that the fluorinated etched surface and its passivation properties can be preserved. This is achieved by capping the surface post-etch with an oxide layer, through a thermal oxidation cycle.

Each etch gas may have its own method of etching radical formation.

In one embodiment the substrate for etching, on which the silicon layer is deposited, may be selected from glass, AlTiC (Aluminum Titanium Carbon), ITO (Indium tin oxide) and FR4 laminates (woven fibreglass cloth with an epoxy resin binder that is flame resistant).

In the specification, the term "silicon layer" should be understood to encompass all thing films/thin deposited silicon layers and expitaxial silicon layers.

The process is performed in an atmospheric reaction process and the surface of the etched silicon substrate is performed in the same process chamber or in an additional process chamber without having the substrate come in contact with ambient air by passing the substrate through purge curtains.

Another significant advantage of this method is that the oxidation rate will be enhanced due to the presence of the etchant gas at the surface of the silicon substrate, considerably reducing the overall thermal budget of the process.

The etchant gas is molecular fluorine and the preferred oxidising species is ozone (O₃).

After this process, the substrate can then be exposed to ambient air and will retain its electrical properties. The resulting layer can be a silicon-oxide-fluoride layer, or similar to Fluorinated Silicon Glass (FSG). The substrate can be subsequently transported safely to another processing tool in order to carry out the remaining manufacturing steps, or stored for later processing.

In one embodiment, the oxidation step of the process can be combined with a doping step, whereby the doping step involves injection of precursors. The precursors are elected from the group comprising tetraethyl orthosilicate (TEOS, Si(OC₂H₅)₄), silane and oxygen, dichlorosilane (SiCl₂H₂) and nitrous oxide (N₂O), trimethylborate (TMB) or triethylborate (TEB), or trimethylphosphate (TMPO) or trimethylphosphite (TMPI), or any combination thereof.

Preferably, the silicon oxide is deposited using a mixture of tetraethoxysilane and ozone gases and at least one selected from trimethylborate (TMB), triethylborate (TEB), trimethylphosphate (TMPO), trimethylphosphite (TMPI), diborane, phosphine, and arsine on top of the etched surface.

In one embodiment, all process steps are carried out at a temperature below about 600 deg. C, preferably below about 500 deg. C, more preferably below about 400 deg. C.

Preferably, all process steps are carried out either in the same atmospheric reaction apparatus or in a subsequent atmospheric reaction chamber separated by nitrogen gas or other inert gas purge curtains in a continuous system. In the specification, the term "continuous system" should be understood to mean that the substrate is constantly moving during each process step, i.e. the substrate velocity is one of the process parameters.

Subsequent steps required to complete the fabrication of a solar cell would then include annealing, deposition of an anti-reflective layer at the front surface, and contacting of the front and back side of the cell. A standard thermal annealing step is required in order to form the emitter, during which the previously deposited dopant atoms are diffused inside the silicon. This anneal step, commonly used by the solar industry, could either be carried out at atmospheric pressure and in the same tool, or at another location and tool, because the surface of the substrate can safely be exposed to air after the oxidation step.

The deposition of an anti-reflective layers in order to reduce the reflectivity of the cell, or increase further the passivation, consists typically of deposition of a defined thickness of silicon nitride using vacuum based plasma enhance chemical vapour deposition tool (PE-CVD).

The advantages of the process of the present invention are that the passivation quality of the fluorinated surface of the substrate is preserved and the final passivation of the resulting substrate (wafer) is improved compared to a standard (solar cell) process. Further, the oxidation rate is enhanced by the fluorinated surface and the overall thermal budget of the process is significantly reduced accordingly. Also, the overall efficiency of the finished cell is improved as a result of the improved passivation. Within the context of solar cell manufacturing, using this new process would also lead to significant simplification and reduction of the number of process steps required. Indeed, the atmospheric pressure hardware (as described in WO 2011/141516) can deliver a single sided process for both texturing and doping/oxidation. This means that the texture and the emitter are formed only at the front side of the cell. Therefore, there is no need to carry out an edge isolation step that is usually required in a standard cell process in order to remove the junction at the back side of the cell. Also, as mentioned previously, the texture created and passivated can be a very efficient light-trapping nano-texture (commonly referred to as "black silicon"), that would not necessarily require the addition of an anti reflective layer (typically SiNx).

In one embodiment of the invention, there is provided a process for etching a texture on a surface of a silicon substrate and passivating said substrate surface, wherein the silicon substrate is a silicon wafer or a silicon layer deposited on a substrate, the process comprising the steps of:
(a) inserting a silicon substrate into a reaction chamber;
(b) heating the reaction chamber and silicon substrate;
(c) etching the surface of the substrate with an etchant gas inside the chamber, while the substrate is being conveyed at a constant velocity; and
(d) oxidising the textured, fluorinated surface of the substrate without exposing the substrate to air; and
wherein the steps are performed at atmospheric pressure and wherein the etchant gas is molecular fluorine.

In one example, not forming part of the invention, the etchant gas is selected from elemental fluorine, elemental chlorine, fluoride-containing compounds or chlorine-containing compounds. The fluoride-containing compounds may be selected from the group comprising tetrafluoromethane, trifluoromethane, carbonyl fluoride, sulphur hexafluoride, nitrogen trifluoride, xenon difluoride, and elemental fluorine. The chlorine-based compounds may be selected from the group comprising tetrachloromethane, a mixture of trichlorosilane and hydrogen, and hydrogen chloride.

In the specification, the term "passivation" or "passivate" should be understood to mean a process by which the substrate becomes less affected by environmental factors such as air or water, and the electrical properties of the substrate are preserved or improved. More specifically for solar cell application, a passivating process reduces surface recombination, a significant loss mechanism for this type of device.

### Brief Description of the Drawings

The invention will be more clearly understood from the following description of an embodiment thereof, given by way of example only, with reference to the accompanying drawings, in which:-
**Figure 1** is a diagram illustrating the dry process of the present invention in the case of 2 separate chambers where the etching is carried out within the first section of the reactor and the oxidation is carried out within the following section of the reactor;
**Figure 2** is a diagram illustrating the dry process of the present invention in the case of 2 separate chambers, where the etching is carried out within the first section of the reactor and the deposition of a doped SiOx layer is carried out within the following section of the reactor;
**Figure 3** is a diagram illustrating the dry process of the present invention in the case of 2 separate chambers with a buffering station in between the two chambers.
**Figure 4** is a diagram illustrating the dry etching process of the present invention in the case where all the steps are carried out sequentially within a single reactor
**Figure 5** is a flow diagram illustrating the various manufacturing steps for a standard cell process and for a cell process incorporating the present invention (alternative cell process flow), and the resulting simplification.

### Detailed Description of the Drawings

The present invention uses a dry-etch chemistry where the etching is not limited by the crystalline structure of the surface to be etched. The etchants are controllably delivered in gaseous form and are applied to the surface to be etched at atmospheric pressure. There is no requirement for the etching zone to be contained in a vacuum chamber, although it is possible to do so.

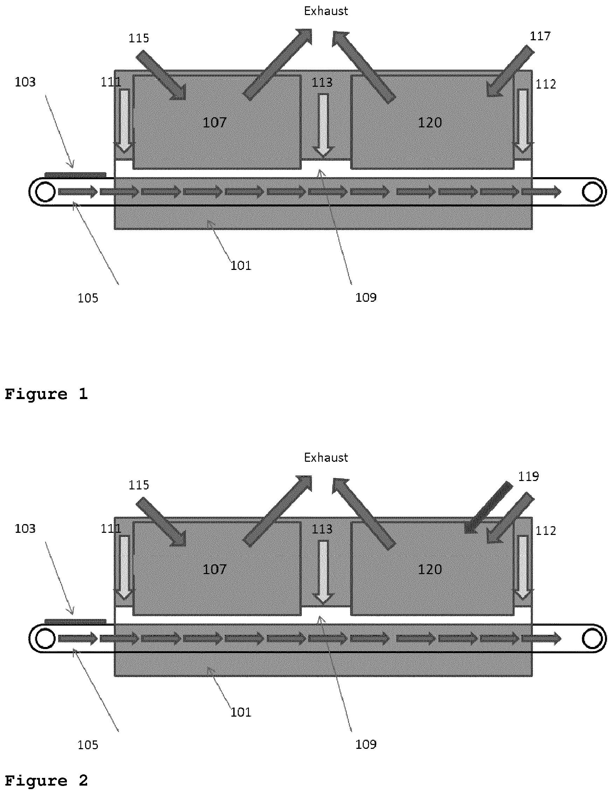

Referring now to Figure 1, there is illustrated an atmospheric reactor 101 adapted to perform the process of the invention. The silicon substrate 103 is placed on a moveable carrier 105, for example, a substrate conveyor, adapted to move continuously to deliver the substrate 103 to an etching zone 107. Only the front side of the substrate is exposed to the process. The reaction area 109 is sealed off by purge curtains 111,112 at the entrance and the exit, respectively.

The etching zone 107 is positioned inside the perimeter boundaries defined by the purge curtains 111,112. The conveyor 105 moves the substrate 103 through the etching zone 107 in a controlled manner such that under an etchant-delivering system 115 inside the reactor 107 at least one etchant in gas form is applied under atmospheric pressure to the substrate 103 in the reactor 107. The etchant gas is molecular fluorine.

The etched substrate 103, that has now a front surface fully saturated with fluorine, is moved through the etching area 107 to the oxidation zone 120, passing under a nitrogen purge curtain 113. The purge curtain 113 separates the two reacting zones 107 and 120, and prevents the mixing of gases from each section. The oxidation of the surface takes place when the now etched substrate 103 enters the oxidation zone 120. The chemical precursor gases are introduced via a gas distribution system 117. The zone 120 is designed in order to grow/deposit the required thickness of a passivating layer while the substrate 103 is continuously moving through the reacting zone 109. Finally, the substrate 103 exits the reactor/reaction area 109 where it can be moved on the next processing station.

Referring now to Figure 2, there is illustrated the same atmospheric reactor, but this time the second section of the reactor zone 120 provides the deposition of a doped silicon-oxide layer, by injection of a combination of TEOS, ozone and phosphorus or boron via the combined pre-doping and oxidising application system 119.

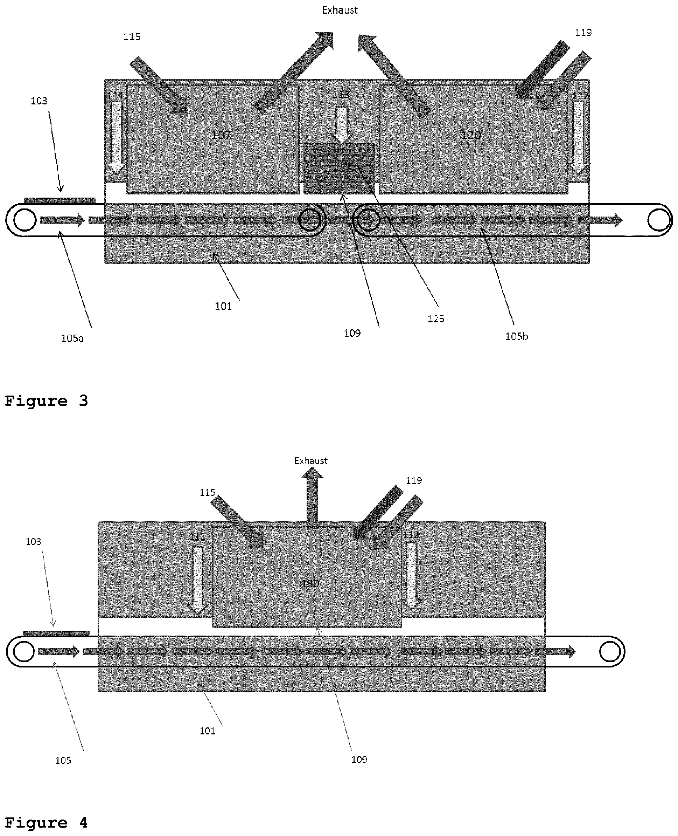

Referring now to Figure 3, there is illustrated the same apparatus and process described in Figure 2 but with a buffering station 125 between the two sections 107 and 120 of the reactor 101. The substrates 103 arriving from the etching section 107 can be buffered and dispatch to the next section 120 at the appropriate speed required by the next process. This buffering section 125 will dissociate the velocity process parameter of the two sequential processes, providing a more flexible overall process control. This embodiment requires at least two independent conveyors 105a, 105b, one for each reacting zone and is the preferred configuration in a high throughput industrial environment.

Referring now to Figure 4, there is illustrated another embodiment where the etching and oxidation steps are carried out in the same reaction chamber. In this particular case, the process is semi-continuous; a substrate 103 or a batch of substrates are introduced inside a reactive zone 130. The conveyor 105 stops, and the first etching step is carried out by injecting the relevant etching gas via the system 115. Once the etching has been done, the precursors required for the oxidation of the surface are then injected via the system 119. Once the oxidation, or deposition of the doped oxide layer is sufficient, the substrate 103 (or batch of substrates) are moved outside the reactive zone 130 where they can be moved on to the next processing station. This scenario is more relevant to a tool that does not require delivering a very high throughput, like for example in a laboratory/ R&D setup.

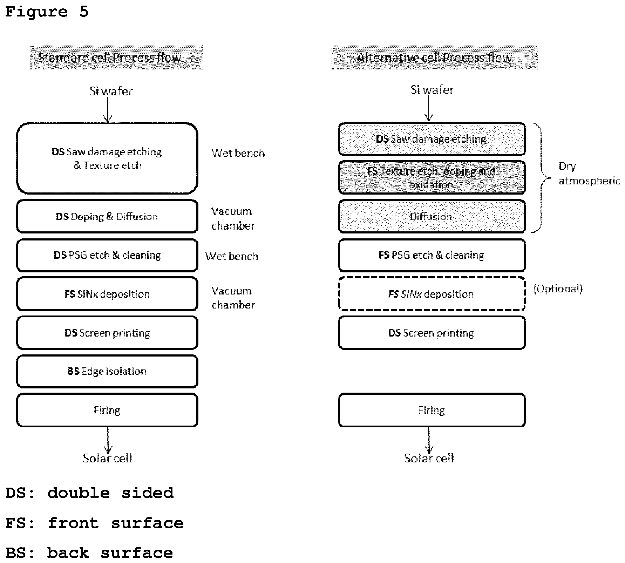

Referring now to Figure 5, there is illustrated the implication of this invention on the overall process flow of solar cell manufacturing. On the left hand side, the process flow and associated steps for a standard industrial cell process are described. On the right side, the solar cell manufacturing process including the steps of the present invention. A standard process requires a succession of wet and dry in-vacuum process steps. Also, most of the steps are carried out on both sides of the wafer. In the process of the present invention, the number of steps and therefore processing tools, are reduced. Because this invention provides a means of doping the substrate before thermal diffusion, and that this doping process can be applied on only one side of the substrate using the hardware described in the previous paragraph, the edge isolation step is no longer required. The resulting manufacturing process requires only between 4 and 5 steps.

In the specification the terms "comprise, comprises, comprised and comprising" or any variation thereof and the terms "include, includes, included and including" or any variation thereof are considered to be totally interchangeable and they should all be afforded the widest possible interpretation and vice versa.

## Claims

1. A process for etching a texture on a surface of a silicon substrate and passivating said substrate surface, wherein the silicon substrate is a silicon wafer or a silicon layer deposited on a substrate, the process comprising the steps of:
(a) inserting a silicon substrate (103) into a reaction chamber (107);
(b) heating the reaction chamber and substrate;
(c) etching the surface of the substrate with a fluoride-containing etchant gas inside the chamber while the substrate is being conveyed at a constant velocity; and
(d) oxidising (120) the textured, fluorinated surface of the substrate without exposing the substrate to air; and
wherein the steps are performed at atmospheric pressure and wherein the etchant gas is molecular fluorine.

2. A process according to Claim 1, wherein the molecular fluorine can be any concentration in a range of between about 5 to 100%, with or without dilution with N₂ or any other gas that does not react with molecular fluorine such as helium, argon, neon, and krypton.

3. A process according to any one of Claims 1 to 2, wherein the oxidising species is ozone.

4. A process according to any one of the preceding claims, wherein the process further comprises a doping step combined with the oxidising step.

5. A process according to Claim 4, wherein the combined oxidation and doping step comprises injection of a precursor into the reaction chamber selected from the group comprising tetraethyl orthosilicate (TEOS, Si(OC₂H₅)₄), silane and oxygen, dichlorosilane (SiCl₂H₂) and nitrous oxide (N₂O), trimethylborate (TMB) or triethylborate (TEB), or trimethylphosphate (TMPO) or trimethylphosphite (TMPI), or any combination thereof; or it comprises optionally depositing a silicon oxide by using a mixture of tetraethoxysilane and ozone gases and at least one selected from trimethylborate (TMB), triethylborate (TEB), trimethylphosphate (TMPO), trimethylphosphite (TMPI), diborane, phosphine, and arsine.

6. A process according to any one of the preceding claims, wherein all process steps are carried out in the same atmospheric reaction apparatus; or wherein all process steps are carried out in a subsequent atmospheric reaction chamber separated by nitrogen gas or other inert gas purge curtains in a continuous system.

7. A process according to any one of the preceding claims, wherein the process steps are applied on only one side of the substrate.

8. A process according to any one of the preceding claims, wherein all process steps are carried out at a temperature below about 600 deg. C.

## Patentansprüche

1. Verfahren zum Ätzen einer Textur auf eine Oberfläche eines Siliciumsubstrats und Passivieren der Substratoberfläche, wobei das Siliciumsubstrat ein Silicium-Wafer oder eine Siliciumschicht ist, die auf einem Substrat aufgebracht ist, wobei das Verfahren die folgenden Schritte umfasst:
(a) Einführen eines Siliciumsubstrats (103) in eine Reaktionskammer (107);
(b) Erhitzen der Reaktionskammer und des Substrats;
(c) Ätzen der Oberfläche des Substrats mit einem Fluorid-haltigen Ätzgas in der Kammer, während das Substrat bei einer konstanten Geschwindigkeit weitergeführt wird; und
(d) Oxidieren (120) der texturierten, fluorierten Oberfläche des Substrats ohne Exposition des Substrats gegenüber Luft; und
wobei die Schritte bei Atmosphärendruck durchgeführt werden und wobei das Ätzgas molekulares Fluor ist.

2. Verfahren nach Anspruch 1, wobei das molekulare Fluor in einer jedweden Konzentration in einem Bereich zwischen etwa 5 bis 100 %, mit oder ohne Verdünnung mit N₂ oder jedwedem anderen Gas, das nicht mit molekularem Fluor reagiert, wie zum Beispiel Helium, Argon, Neon und Krypton, vorliegen kann.

3. Verfahren nach einem der Ansprüche 1 bis 2, wobei die oxidierende Spezies Ozon ist.

4. Verfahren nach einem der vorstehenden Ansprüche, wobei das Verfahren weiter einen Dotierungsschritt umfasst, der mit dem Oxidationsschritt kombiniert ist.

5. Verfahren nach Anspruch 4, wobei der kombinierte Oxidations- und Dotierungsschritt das Einspritzen einer Vorstufe in die Reaktionskammer umfasst, die aus der Gruppe ausgewählt ist, die Folgende umfasst: Tetraethylorthosilicat (TEOS, Si(OC₂H₅)₄), Silan und Sauerstoff, Dichlorsilan (SiCl₂H₂) und Distickstoffoxid (N₂O), Trimethylborat (TMB) oder Triethylborat (TEB) oder Trimethylphosphat (TMPO) oder Trimethylphosphit (TMPI), oder jedweder Kombination davon; oder es umfasst optional das Aufbringen eines Siliciumoxids durch Verwendung einer Mischung aus Tetraethoxysilan- und Ozongasen und mindestens eines, das aus Folgenden ausgewählt ist: Trimethylborat (TMB), Triethylborat (TEB), Trimethylphosphat (TMPO), Trimethylphosphit (TMPI), Diboran, Phosphan und Arsan.

6. Verfahren nach einem der vorstehenden Ansprüche, wobei alle Verfahrensschritte in der gleichen atmosphärischen Reaktionsvorrichtung durchgeführt werden; oder wobei alle Verfahrensschritte in einer nachfolgenden atmosphärischen Reaktionskammer, die durch Spülungsvorhänge von Stickstoffgas oder anderem Inertgas abgetrennt ist, in einem kontinuierlichen System durchgeführt werden.

7. Verfahren nach einem der vorstehenden Ansprüche, wobei die Verfahrensschritte nur auf einer Seite des Substrats angewendet werden.

8. Verfahren nach einem der vorstehenden Ansprüche, wobei alle Verfahrensschritte bei einer Temperatur unter etwa 600 Grad C durchgeführt werden.

## Revendications

1. Procédé de gravure d'une texture sur la surface d'un substrat de silicium et de passivation de ladite surface de substrat, où le substrat de silicium est une tranche de silicium ou une couche de silicium déposée sur un substrat, le procédé comprenant les étapes consistant à :
(a) insérer un substrat de silicium (103) dans une chambre de réaction (107) ;
(b) chauffer la chambre de réaction et le substrat ;
(c) graver la surface du substrat par un gaz de gravure contenant du fluorure à l'intérieur de la chambre, tandis que le substrat est transporté à une vitesse constante ; et
(d) oxyder (120) la surface texturée fluorée du substrat, sans exposer le substrat à l'air ; et
dans lequel les étapes sont mises en œuvre à la pression atmosphérique et où le gaz de gravure est constitué de fluor moléculaire.

2. Procédé selon la revendication 1, dans lequel le fluor moléculaire peut se trouver selon une concentration quelconque dans une plage entre environ 5 à 100%, avec ou sans dilution par du N₂ ou tout autre gaz qui ne réagit pas avec le fluor moléculaire, tel que l'hélium, l'argon, le néon, et le krypton.

3. Procédé selon l'une quelconque des revendications 1 à 2, dans lequel l'espèce oxydante est constituée d'ozone.

4. Procédé selon l'une quelconque des revendications précédentes, le procédé comprenant en outre une étape de dopage combinée avec l'étape d'oxydation.

5. Procédé selon la revendication 4, dans lequel l'étape combinée d'oxydation et de dopage comprend l'injection d'un précurseur dans la chambre de réaction, choisi dans le groupe comprenant l'orthosilicate de tétraéthyle (TEOS, Si(OC₂H₅)₄), le silane et l'oxygène, le dichlorosilane (SiCl₂H₂) et l'oxyde nitreux (N₂O), le borate de triméthyle (TMB) ou le borate de triéthyle (TEB), ou le phosphate de triméthyle (TMPO) ou le triméthylphosphite (TMPI), ou une combinaison quelconque de ceux-ci ; ou elle comprend éventuellement le dépôt d'un oxyde de silicium par l'utilisation d'un mélange de tétraéthoxysilane et d'ozone gazeux et d'au moins l'un choisi parmi le borate de triméthyle (TMB), le borate de triéthyle (TEB), le phosphate de triméthyle (TMPO), le triméthylphosphite (TMPI), le diborane, la phosphine, et l'arsine.

6. Procédé selon l'une quelconque des revendications précédentes, dans lequel toutes les étapes de procédé sont mises en œuvre dans le même appareil de réaction atmosphérique ; ou où toutes les étapes de procédé sont mises en œuvre dans une chambre de réaction atmosphérique ultérieure séparée par des rideaux de purge d'azote gazeux ou de tout autre gaz inerte dans un système continu.

7. Procédé selon l'une quelconque des revendications précédentes, dans lequel les étapes de procédé ne sont appliquées que sur un seul côté du substrat.

8. Procédé selon l'une quelconque des revendications précédentes, dans lequel toutes les étapes de procédé sont mises en œuvre à une température inférieure à environ 600°C.
